# EUROPEAN PATENT APPLICATION

(11) **EP 4 722 808 A1**
(43) Date of publication of application: **08.04.2026**
(21) Application number: 24204234.9
(22) Date of filing: 02.10.2024
(51) Int. Cl.: G03F 7/00

(54) **EXPOSURE APPARATUS RADIATION PULSE INTENSITY MODULATION**

(71) Applicant: ASML Netherlands B.V., 5500 AH Veldhoven (NL)
(72) Inventor: BLOK, Sander, 5500 AH Veldhoven (NL); SAMBRICIO, Jose, Luis, 5500 AH Veldhoven (NL); MARIN FERNANDEZ, Enrique, 5500 AH Veldhoven (NL)
(74) Representative: ASML Netherlands B.V.

(57) **Abstract**

A method of improving contrast in an exposure apparatus is disclosed. The exposure apparatus receives a plurality of radiation pulses from a radiation source, the method comprises modulating an intensity of the radiation pulses. In an embodiment, the intensity of the radiation pulses is modulated according to a time profile. The modulation may set an intensity of the pulses to maximize at least one image quality parameter of at least one critical feature of a pattern of the patterning device.

## Description

### FIELD

The present invention relates to a method of improving contrast in an exposure apparatus, a radiation pulse intensity control device, an exposure apparatus comprising said radiation pulse intensity control device and a software program product comprising program instructions configured to carry out the steps according to said method.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

EUV illuminators may generate a slit intensity profile which varies along a scanning direction, the slit intensity profile may for example be approximately trapezoidal in shape, when seen along a scanning direction. Image fading may be understood as when imaging conditions, for example illumination shape or projection lens aberrations, are different along the scanning direction. As a final image may be a sum of all the images produced during different pulses and hence at different locations along the scanning direction, the final image may then be smeared out and degraded in contrast. In the example of the trapezoidal shape, a leading and trailing slope of the trapezoidal shape may result in image fading and contrast loss when projecting the pattern at the patterning device onto the substrate.

It is desirable to enhance a performance of the lithographic apparatus, such as a throughput, an image quality, an overlay error, a line size, and others.

### SUMMARY

In a first aspect, there is provided a method of improving contrast in an exposure apparatus, wherein the exposure apparatus receives a plurality of radiation pulses from a radiation source, the method comprising: modulating an intensity of the radiation pulses.

In a second aspect, there is provided a radiation pulse intensity control device, the radiation pulse intensity control device comprising a modulator configured to modulate an intensity of radiation pulses in an exposure apparatus and a control device configured to control the modulator.

In a third aspect, there is provided an exposure apparatus comprising said radiation pulse intensity control device.

In a fourth aspect, there is provided a software program product comprising program instructions configured to, when the software program product is executed by a data processing device, cause the data processing device to carry out the steps according to said method.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a generally circular portion of the field facet mirror device of the lithographic system shown in Figure 1, showing a central obscuration portion and two portions which receive radiation;
- Figure 2B shows an example shape of a field facet for a faceted field mirror device in a known EUV lithographic apparatus of the form shown in Figure 1;
- Figure 3A depicts a schematic view of a light slit in an X Y plane and Figure 3B depicts a cross section of an intensity of the slit in y direction;
- Figure 4A depicts a time sequence of radiation pulses and Figure 4B depicts a schematic view of a light slit in an X Y plane;
- Figure 5A depicts an intensity profile of the slit in the Y direction at a measurement pulse frequency and Figure 5B depicts a measured intensity of the slit at a radiation pulse frequency;
- Figure 6 depicts an intensity profile of the slit in the Y direction at a variety of intensity modulation frequencies; and
- Figure 7A - 7C depict projection results of projecting a pattern on the substrate by three different pulses, and 7D depicts a combined result of the projections.

### DETAILED DESCRIPTION

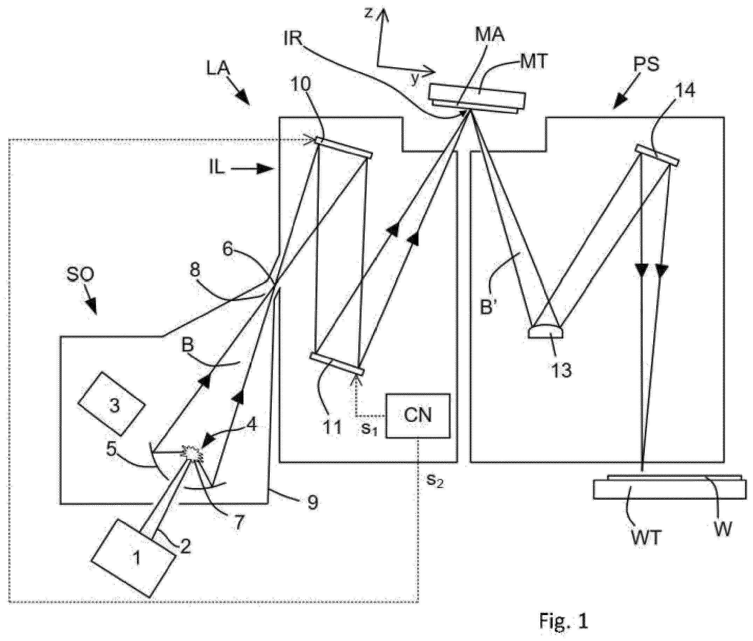

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

The lithographic apparatus LA further comprises a controller CN that is operable to control a configuration of the faceted field mirror device 10 and faceted pupil mirror device 11. To achieve this, the controller CN may be operable to send a suitable control signal s1, s2 to each of the faceted pupil mirror device 11 and the faceted field mirror device 10.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The radiation source SO shown in Figure 1 is, for example, of a type which may be referred to as a laser produced plasma (LPP) source. A laser system 1, which may, for example, include a CO2 laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below .

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The angular distribution of radiation at the patterning device MA may be referred to as the illumination mode. It may also be referred to as the pupil or pupil fill. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit. Said illumination region may comprise the only region of the patterning device illuminated by said at least a portion of the EUV radiation beam B at any instance of time.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled. As such, an illumination pupil plane may comprise any angularly resolved plane between the illumination source and the substrate (e.g., within the illumination branch). This spatial distribution of the radiation in an illumination pupil plane may be referred to as the illumination pupil profile or simply the illumination pupil. In a conventional illumination mode, the radiation uniformly fills a circular region of the illumination pupil plane centred on the optical axis such that each point on the patterning device is illuminated by a solid cone of light. In dipole illumination mode, the radiation fills two regions of the illumination pupil plane that are spaced apart from, and on opposite sides to, the optical axis. Many other illumination modes are known. In principle, an optimum illumination mode can be defined to image a given pattern under given conditions. Therefore, it is desirable to provide flexibility in the illumination mode.

The uniformity of the illumination is also important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

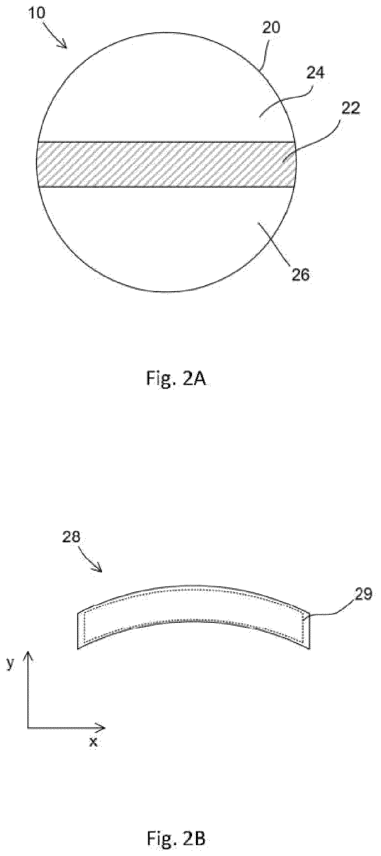

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2A a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

A known faceted field mirror device 10 used in an EUV lithographic apparatus of the type shown in Figure 1 is now described with reference to Figures 2A and 2B.

In known EUV lithographic apparatus, the faceted field mirror device 10 comprises a plurality of field facets. In particular, in such known EUV lithographic apparatus, the portions 24, 26 of the faceted field mirror device 10 that receive radiation from the radiation source SO are provided with a plurality of field facets. For example, the portions 24, 26 of the faceted field mirror device 10 that receive radiation from the radiation source SO may be provided with of the order of 100 field facets (for example 300 field facets). In a plane of the faceted field mirror device 10 each field facet may have a curved shape 28, as shown in Figure 2B. In general, in the plane of the faceted field mirror device 10 each field facet may have an elongate shape having a longer dimension in an x-direction and a shorter dimension in a y-direction. Each field facet comprises a mirror that may be arranged to image the intermediate focus 6 onto the faceted pupil mirror device 11. To achieve this, the field facets may, for example, be concave.

The faceted pupil mirror device 11 comprises a plurality of pupil facets. The faceted pupil mirror device 11 is arranged to project an image of each field facet of the faceted field mirror device 10 onto an illumination region IR (also referred to as the slit or illumination slit) at the patterning device MA. The illumination system IL is configured so that each field facet is imaged on the illumination region IR in an overlapping manner. Desirably, in such known lithographic apparatus, each image of a field facet fills the illumination region IR. The overlap of the images of the field facets at least partially evens out irregularities in the radiation beam B provided by the radiation source SO.

The illumination region IR may be curved or straight. In general, in a scanning lithographic apparatus LA, the illumination region IR is elongate having a longer dimension and a shorter dimension. The shorter dimension may coincide with a scanning direction or y-direction of the support structure MT and the longer dimension may coincide with a non-scanning direction or x-direction. The illumination region IR may be curved or straight. The illumination region IR is indicated in Figure 1, which shows the patterning device in cross section. The longer dimension (in the x-direction) of the illumination region IR is perpendicular to the plane of Figure 1 and the shorter dimension (in the y direction) of the illumination region IR lies in the plane of Figure 1.

It will be appreciated that the illumination region IR may have a shape in the plane of the patterning device MA that generally corresponds to that of each of the field facets, for example being generally of the form of the shape 28 shown in Figure 2B. Note that the shape and size of the projection of each field facet onto the plane of the patterning device MA may not be exactly the same as the illumination region IR and will depend on the magnification factors applied in the x and y directions by the field facet, the pupil facets (and any other optics in upstream of the illumination region IR). The edges of the illumination region IR may be defined by two sets of patterning device masking blades (not shown), which may truncate the radiation such that radiation is not incident on the patterning device outside of the illumination region IR. Therefore, in such known lithographic apparatus, each of the field facets may be arranged such that in the absence of such patterning device masking blades they would each overfill the illumination region IR. The illumination region IR may receive radiation from a central portion of each field facet, as indicated by the dotted line 29 inside the example shape 28 of a field facet shown in Figure 2B.

Therefore, in some existing EUV lithographic apparatus, a region surrounding the illumination region IR is also provided with EUV radiation (although the illumination region at the patterning device MA is masked from this portion of the EUV radiation, which is not used for exposing the substrate W). This region surrounding the illumination region IR may receive EUV radiation from an edge portion of each field facet mirror (which may be the portion disposed between the dotted line 29 and the edge of shape in the schematic illustration in Figure 2B). At least a part of this portion of the EUV radiation that is not used for exposing the substrate W may be incident on an energy sensor, which may be used to monitor and control a dose of radiation that is delivered to the substrate W.

It has been proposed to use a faceted field mirror device 10 and/or a faceted pupil mirror device 11 having a larger number of individually directable or movable reflective optical elements so as to provide better control over the illumination modes of the lithographic apparatus. For example, it has been proposed to use a faceted field mirror device 10 and/or a faceted pupil mirror device 11 comprising a micro-electromechanical system (MEMS) micro-mirror array. In a typical lithographic system, a pattern on a patterning device is illuminated and the resulting diffraction is collected and projected to form an aerial image at the substrate level. The aerial image may trigger a photochemical reaction in a photoresist layer on the substrate. Thus, a pattern may be transferred from the patterning device to the substrate. An EUV lithography tool may use an EUV reflective patterning device that may consist of a multilayer stack having EUV reflection portions and EUV absorption portions to define a pattern. A typical EUV mask in high volume manufacturing scenarios may, for example, use a tantalum (Ta) absorber. In some cases, for example when a pattern is highly regular and/or dense, an EUV mask may comprise an attenuated phase shift mask.

Typical EUV systems may optimize a pupil to increase printability and for high throughput for a given pattern on a patterning device, however, typical EUV illuminators may not have flexibility to control an angular distribution from layer to layer (i.e. different pupils from patterning device to patterning device). Thus, there may not be control over a pupil in an expose field. This lack of flexibility may be intrinsic to an optical design of the illumination system.

A reflective patterning device (e.g., an EUV patterning device) may have an incident/diffraction angle dependent phase shift between diffraction orders. This may lead to misalignment of an aerial image at substrate level between different incidence angles. For a patterning device based on absorption and reflection (e.g., a Ta patterning device) this effect is known as mask shadowing effects, "mask 3D effects", or" M3D fading". M3D fading may also persist in attenuated phase shift masks. The main disadvantage of M3D fading is contrast loss. For example, an optimal pupil for a particular use case may be a y-dipole. An aerial image at substrate level may be a superposition of a north pole of the y-dipole and a south pole of the y-dipole. Experimentally, the aerial images from the north and the south pole may be aligned at substrate level to achieve optimal contrast. In practice, owing to patterning device induced fading, the images from the north and south poles may be mis-aligned which may result in a sub-optimal contrast, or contrast loss.

Current EUV illuminators generate a slit intensity profile which has a trapezoidal shape in the scan direction (y direction). The slopes of the trapezoidal shape cause the pupil through scan to be unstable which leads to "sunset" and "sunrise" mask shadowing or mask 3D effects and consequent y location (scan direction location) dependent image fading. The "sunset" and "sunrise" mask shadowing results in a loss of illumination at angles corresponding to an upper part of the illumination pupil (at a first end of the slit in the y-direction) or lower part of illumination pupil (at a second end of the slit in the y-direction). This mask shadowing effect is one of the most important contributors to image contrast degradation. The physical effect at substrate level is a pattern shift of the imaged pattern having a magnitude which varies with y-location along the scan.

More generally, the y-direction dependent pattern shift variation on the substrate results from a y-direction dependent illumination pupil, which changes at substrate level along the scan due to non-ideality of the illuminator.

Although this effect is based on a physical mechanism (mask shadowing), an improper evaluation typically results in attributing the effect to other causes such as projection system aberrations (lens aberrations or aberrations of optical elements within the projection system). This means that it may presently be addressed by inducing a change of the projection system state which is not ideal, and results in less projection system correction potential for correcting true projection system aberration. This approach has limited solution space as the projection system has little correction potential. Other methods have been proposed, all based on a fixed set of settings (static correction), exploiting the current hardware, such as illumination pupil optimization and/or different illuminator improvements.

A proper attribution of the mask shadowing effect allows more appropriate and effective strategies to correct or mitigate for this effect. Currently, there is no dedicated strategy for determining the fading impact and separating this from the projection system aberration impact. The concepts disclosed herein also provide for a dynamic correction, as opposed to many of the aforementioned methods which are static.

Additionally, existing correction interfaces such as, for example for overlay correction, do not take into account possible fading degradation.

It is therefore proposed to improve a contrast in an exposure apparatus which receives a plurality of radiation pulses from a radiation source, by modulating an intensity of the radiation pulses. An effect of the different radiation pulses on a specific part of the pattern may be different. Therefore, when modulating an intensity of the radiation pulses, an effect of the different radiation pulses on the pattern projected on the substrate may differ, which may enable to enhance the pattern projected onto the substrate. Enhancing the pattern projected onto the substrate may for example comprise improving a contrast of the pattern projected onto the substrate. The modulation of the intensity of the radiation pulses may enable to enhance a feature of the pattern, such as a critical feature, or may enhance the pattern as a whole. The exposure apparatus may comprise a lithographic apparatus, such as the lithographic apparatus described with reference to Figure 1.

In an embodiment, the intensity of the radiation pulses is modulated according to a time profile, i.e. a profile of the intensity of the radiation pulses over time. The time profile may extend over a scanning time to expose the slit in the scanning direction. The time profile may take account of the effect of the different radiation pulses on a specific part of the pattern. The time profile may be predetermined, for example making use of a simulation tool which is configured to simulate an effect of each of the radiation pulses in the pattern projected on the substrate, and an optimization tool which is configured to adjust the time profile so as to enhance the pattern projected onto the substrate, for example enhance a contrast of the pattern projected onto the substrate.

In an embodiment, the exposure apparatus images a pattern on a patterning device onto a substrate during a scanning exposure, and wherein the time profile at least partly corresponds to a duration of the scanning exposure, the method comprising modulating the intensity of the radiation pulses according to the time profile during the scanning exposure. The time profile may accordingly be determined to modulate the radiation pulse intensity during the scanning exposure. The pattern on the patterning device may be taken into account: an image of relevant or critical features in the pattern projected onto the substrate may be enhanced.

In an embodiment, the time profile is associated with the patterning device. For different patterning device, e.g. each comprising a different pattern, a time profile may be set per patterning device. An optimization may be performed per patterning device. For example, a simulation may be performed per patterning device, to simulate an effect of each of the radiation pulses in the pattern projected on the substrate, and an optimization may be performed per patterning device to adjust the time profile so as to enhance the pattern projected onto the substrate, for example enhance a contrast of the pattern projected onto the substrate. As a further example, in case different parts of the reticle/patterning device would have slightly different features, which might require a different time profile. In this case, the time profile can be set per part of the patterning device.

In an embodiment, the time profile is further associated with an optical transfer function of a projection system of the exposure apparatus. The characteristics, such as the transfer function of the projection system of the exposure apparatus may differ. On the one hand, the transfer function may differ per exposure apparatus, e.g. due to component tolerances, adjustment tolerances, etc. On the other hand, settings of the projection system may differ: For example, when making use of adjustable mirror segments of a projection mirror, an adjustment of a positioning of the mirror segments may affect the transfer function of the projection system. The time profile may accordingly be set to take account of the transfer function of the projection system. The optical transfer function may also change as a function of field position in X and Y, i.e. in the horizontal plane.

In an embodiment, the time profile is configured to set an intensity of the pulses to maximize an image quality of at least one critical feature of a pattern of the patterning device. A critical feature may be defined as a part of the pattern of the patterning device that is relatively difficult to image on the substrate. When determining the time profile, an image quality of the projection of the critical feature(s) may be enhanced, e.g. at a cost of an image quality of less critical feature(s). For example, a weight factor may be applied, to put more weight on a critical features during the simulation and optimization process as referred to above.

In an embodiment, the method comprises determining the time profile by: identifying at least one critical feature of a pattern of the patterning device; defining at least one imaging quality parameter to be controlled for the critical feature of the pattern; and setting in the time profile an intensity of the pulses to control the at least one imaging quality parameter of the at least one critical feature of the pattern of the patterning device. Having identified one or more critical features of the pattern, and having defined at least one imaging quality parameter to be controlled, such as contrast, the time profile may be set to enhance the image quality feature of the critical feature. For example, the simulation and optimization process as referred to above may be applied. A weight factor may be applied, image quality could for example also be a weighted combination of contrast and placement error.

According to an aspect, there is provided a radiation pulse intensity control device, the radiation pulse intensity control device comprising a modulator configured to modulate an intensity of radiation pulses in an exposure apparatus and a control device configured to control the modulator.

According to an aspect, there is provided an exposure apparatus comprising said radiation pulse intensity control device.

According to an aspect, there is provided a software program product comprising program instructions configured to, when the software program product is executed by a data processing device, cause the data processing device to carry out the steps according to said method.

With the radiation pulse intensity control device, the exposure apparatus and the software program product, the same or similar advantages and effects may be achieved as with the method according to the invention. Also, the same or similar embodiments may be provided, achieving the same or similar advantages and effects as described with reference to said method.

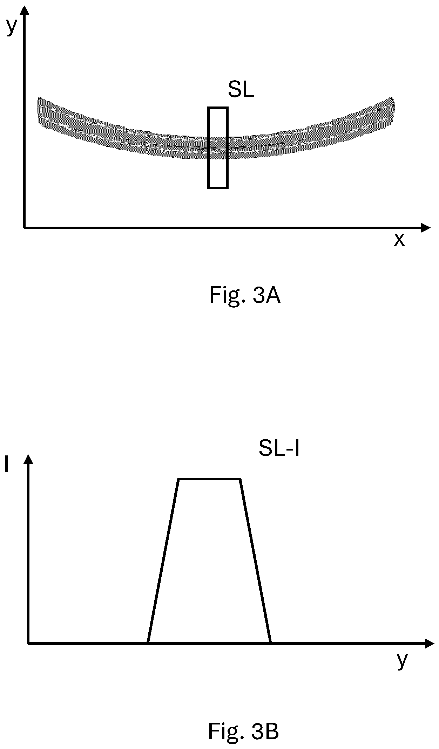

Reverting to the figures, Figure 3A schematically depicts an X Y plane defining the imaging plane of the substrate on which the pattern is to be projected by the exposure apparatus. The Y direction may be defined as the scanning direction. A slit SL through which the radiation pulses are projected on the substrate, is schematically depicted in Figure 3A. The radiation pulses projected via the slit may have a different intensity in the x-y plane. Fig. 3B depicts a view of the radiation intensity I on the vertical axis versus the Y direction along the slit in the horizontal direction. Accordingly, a cross section of the slit intensity SL-I in the y direction is depicted for a single pulse.

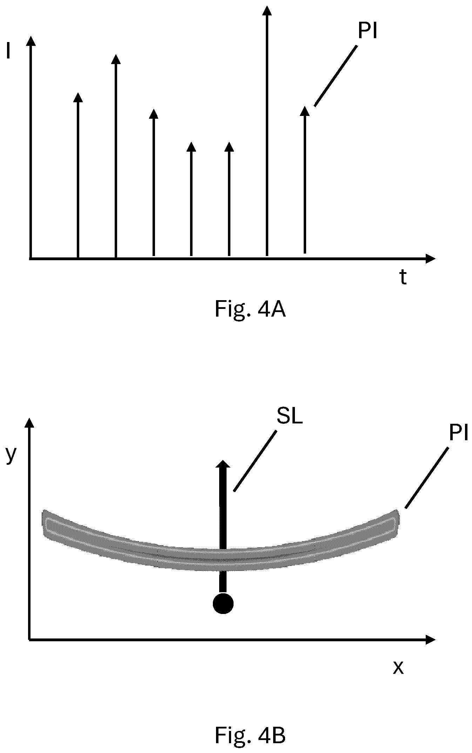

Each radiation pulse is formed by, for example, generating a plasma and radiating a laser excitation pulse on the plasma to emit the EUV radiation pulse. A radiation intensity of the successive radiation pulses may vary, for example due to differences in plasma formation per pulse. Further ways of EUV generation may also possible, such as free electron lasers, synchrotrons or an arcing type of EUV source with spinning tin wheels. Figure 4A depicts an example of a time sequence of radiation pulses, with intensity I along the vertical axis and time t along the horizontal axis, showing an example of varying pulse intensity PI of the radiation pulses, which radiation pulses illuminate the slit. The intensity of each pulse has a certain randomness due to physics.

Fig. 4B depicts the slit SL in the X Y plane, similarly to Figure 3A. During operation, the substrate and reticle (i.e. the patterning device) are scanned through the slit.

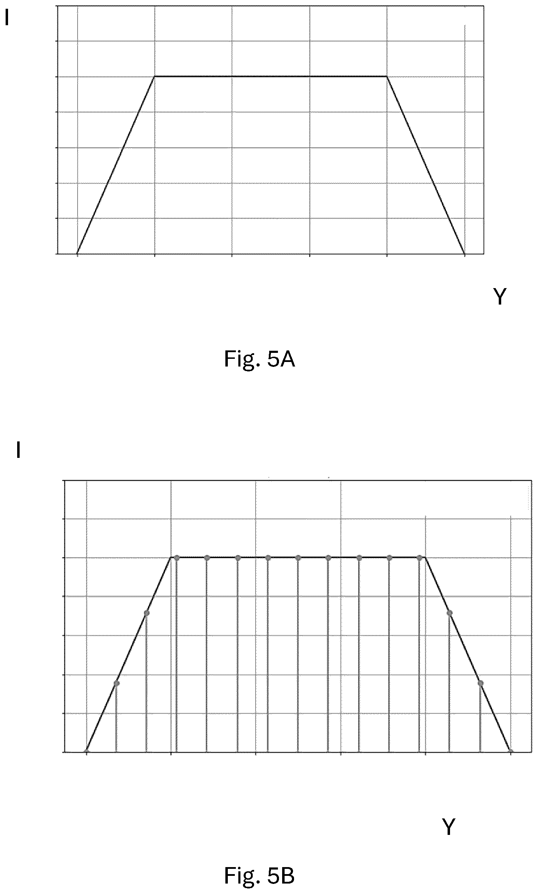

As a result of the successive radiation pulses, for each point on the substrate and the patterning device, a total intensity is a sum of the individual pulses, weighted by a slit shape as depicted in Figure 3B. Mathematically, the total intensity as received by a feature may be understood as a multiplication. A more detailed view of the intensity of the slit along the Y direction is depicted in Figure 5A. The fading may result when imaging conditions (for example illumination shape or the projection lens aberrations) are different along the scanning direction. As the final image may be a sum of the images produced during different pulses and hence at different locations along the scanning direction, the final image may be smeared out and be degraded in contrast. For example, fading may occur at the leading and trailing edge of the slit.. The effect of fading along the y direction may be weighted with the intensity of the slit at each point, as illustrated by Figure 5B. The aberrations may change through the Y direction. While Figure 5A depicts an illumination profile of the slit as continuous, the image at the substrate may be a superposition of all projections formed by successive radiation pulses that affects each individual position at wafer level, weighted by the intensity of the radiation pulse.

The curve as depicted in Figure 5A may typically be measured using hundreds or thousands of pulses per point on the curve. In reality however, the slit may only be hundreds of pulses (depending on source power and dose) or less. The higher a scanning velocity at a given pulse repetition rate, the lower a number of pulses that may project the pattern on a location on the substrate. As illustrated by Figure 4A, an energy per radiation pulse may vary. A dose control loop may ensure that a sum of the radiation pulses is within a more narrow range to control a total dose of radiation pulses on a location on the substrate. However, the distribution of pulse energy per radiation pulse within the slit may be pseudorandom. The pseudorandom distribution of pulse energy implies that the weights used to calculate a fading of the projection optics and a fading of the pupil may only be an average for all points on the substrate respectively the patterning device.

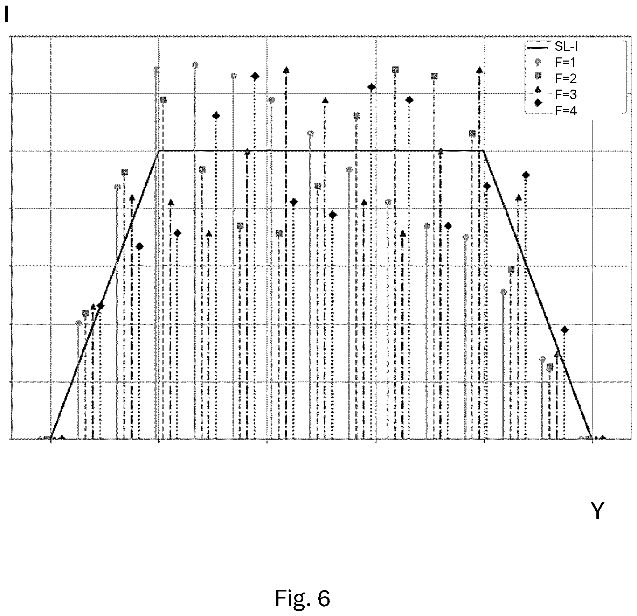

According to the present development, it is proposed to modulate the intensity of the radiation pulses. The intensity of the radiation pulses may be modulated according to a time profile. Figure 6 reproduces the curve of the intensity SL-I along the Y direction of the slit in accordance with Figure 5A, while Figure 6 further illustrates examples of modulation of the intensity of the radiation pulses over time at different pulse intensity modulation frequencies. For example, a sinusoidal wave modulation is applied to the radiation pulse intensity, whereby in Figure 6, the modulation frequency 1 has been set so as to provide a modulation repetition period of the slit width in Y direction, the modulation frequency 2 has been set so as to provide a modulation repetition period of a half of the slit width in Y direction, the modulation frequency 3 has been set so as to provide a modulation repetition period of a third of the slit width in Y direction, and the modulation frequency 4 has been set so as to provide a modulation repetition period of a quarter of the slit width in Y direction. Thus, Figure 6 depicts an increasing modulation frequency of the radiation pulses, as may be identified as modulation frequency 1, 2, 3, 4. Although in the depicted example, a sinusoidal wave modulation is used, any other function may be possible. As another example of modulation, single pulse control may be applied. Knowing which areas of the pattern to be projected on the substrate are more critical and the optics properties, an imaging of the critical areas may be enhanced, possibly at the cost of other, less critical areas of the pattern on the substrate.

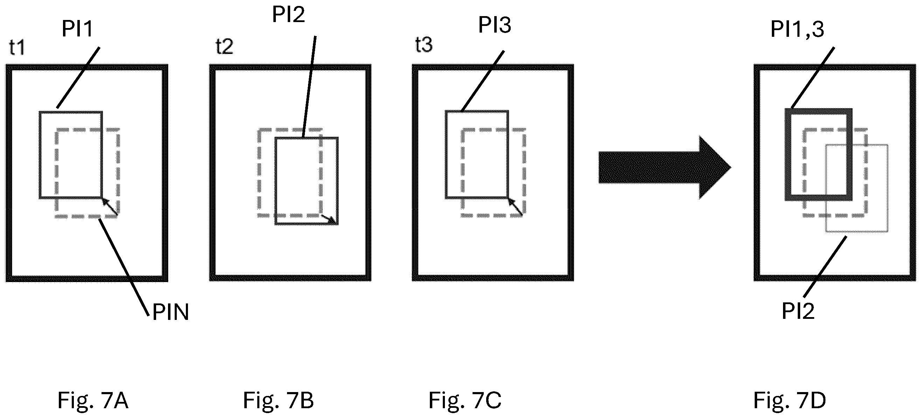

Figure 7A - 7C depict a consecutive projection of a feature of a pattern from a patterning device onto a substrate. In the example as illustrated, the feature is projected three times onto the substrate, namely by three consecutive radiation pulses from the source of radiation. Due to the scanning movement of the substrate as well as the patterning device, the first, second and third radiation pulses project the feature onto the substrate at different positions in the field. An optical transfer function of the exposure apparatus may be shifted in the substrate due to the scanning movement and at the same time, the intensity of the pulse may change due to a pseudo randomness of a normal exposure and/or the modulated intensity. The three different projections by the three radiation pulses may accordingly result in three different projection images PI1, PI2, PI3 of the feature of the pattern on the substrate. The projection images may be different in various respects. In the present illustrative example, the projection images differ in their respective position on the substrate. explained above, due to scanning of the patterning device and the substrate, each pulse propagates through a different part of the projection system. In this example, each part of the projection system causes a shift of the image. As shown in Figure 7A and 7C respectively, the first projection image PI1 and third projection image PI3 are projected with an offset to the left and an offset upwards relative to a desired, nominal projection image PIN, while the second projection image PI2 is projected with an offset to the right and an offset downwards. The final image in accordance with Figure 7D is formed by a sum of the images PI1, PI2 and PI3 formed by the successive radiation pulses.

In this example, one could assume that the placement error could be taken into account in the design (e.g. due to design or other system corrections, or on could take this placement as reference). Since the final image by PI1, PI2 and PI3 is a sum of the three pulses and the image PI2 of pulse 2 deviates from the images PI1, PI3 of pulse 1 and 3, a contribution by PI2 may be minimize. Therefore it may be desirable to modulate the intensity of the radiation pulses to a high pulse intensity at pulse 1 and 3, and low intensity at pulse 2. The final image may then be least affected by the shifted image.

An optimization may be performed, whereby at least one feature in the pattern is identified as being critical, and whereby a modulation of the intensity of the radiation pulses is determined so as to enhance, e.g. improve or optimize, a quality of the critical feature. A criterium for the optimization may be defined. In the example described above with reference to Figures 7A - 7D, contrast is optimized. Other than contrast, further examples of the criterium for enhancement of the critical feature may comprise for example a placement error, a dose, a proximity bias, or a combination of two or more of these criteria.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of improving contrast in an exposure apparatus, wherein the exposure apparatus receives a plurality of radiation pulses from a radiation source, the method comprising:
- modulating an intensity of the radiation pulses.

2. The method according to claim 1, wherein the intensity of the radiation pulses is modulated according to a time profile.

3. The method according to claim 2, wherein the exposure apparatus images a pattern on a patterning device onto a substrate during a scanning exposure, and wherein the time profile at least partly corresponds to a duration of the scanning exposure, the method comprising modulating the intensity of the radiation pulses according to the time profile during the scanning exposure.

4. The method according to claim 3, wherein the time profile is associated with the patterning device.

5. The method according to any one of claim 2 - 4, wherein the time profile is further associated with an optical transfer function of a projection system of the exposure apparatus.

6. The method according to any one of claims 2-5, wherein the time profile is configured to set an intensity of the pulses to maximize an image quality of at least one critical feature of a pattern of the patterning device.

7. The method according to any one of claims 2 - 6, comprising determining the time profile by:
- identifying at least one critical feature of a pattern of the patterning device;
- defining at least one imaging quality parameter to be controlled for the at least one critical feature of the pattern;
- setting in the time profile an intensity of the pulses to control the at least one imaging quality parameter of the at least one critical feature of the pattern of the patterning device.

8. A radiation pulse intensity control device, the radiation pulse intensity control device comprising a modulator configured to modulate an intensity of radiation pulses in an exposure apparatus and a control device configured to control the modulator.

9. The radiation pulse intensity control device according to claim 8, wherein the control device is configured to control the modulator to modulate the intensity of the radiation pulses according to a time profile.

10. The radiation pulse intensity control device according to claim 9, wherein the exposure apparatus images a pattern on a patterning device onto a substrate during a scanning exposure, and wherein the time profile at least partly corresponds to a duration of the scanning exposure, wherein the control device is configured to control the modulator to modulate the intensity of the radiation pulses according to the time profile during the scanning exposure.

11. The radiation pulse intensity control device according to claim 10, wherein the control device is configured to associate the time profile with the patterning device.

12. The radiation pulse intensity control device according to any one of claim 9 - 11, wherein the control device is configured to further associate the time profile with an optical transfer function of a projection system of the exposure apparatus.

13. The radiation pulse intensity control device according to any one of claims 9 - 12, wherein the time profile is configured to maximize an image quality of at least one critical feature of a pattern of the patterning device.

14. The radiation pulse intensity control device according to any one of claims 9 - 13, wherein the control device is configured to determine the time profile by:
- receiving input data identifying at least one critical feature of a pattern of the patterning device;
- receiving input data defining at least one imaging quality parameter to be controlled for the at least one critical feature of the pattern;
- setting in the time profile an intensity of the pulses to control the at least one imaging quality parameter of the at least one critical feature of the pattern of the patterning device.

15. An exposure apparatus comprising the radiation pulse intensity control device according to any one of claims 8-14.

16. A software program product comprising program instructions configured to, when the software program product is executed by a data processing device, cause the data processing device to carry out the steps according to the method according to any one of claims 1-7.
